Europäisches Patentamt

European Patent Office

Office européen des brevets

(19)

(11) Veröffentlichungsnummer: **0 024 572**
**B1**

(12) # EUROPÄISCHE PATENTSCHRIFT

(45) Veröffentlichungstag der Patentschrift:
**10.06.87**

(51) Int. Cl.⁴: **H 01 L 29/40**, H 01 L 23/48

(21) Anmeldenummer: **80104532.9**

(22) Anmeldetag: **31.07.80**

(54) **Elektrisch leitender Kontakt- oder Metallisierungsaufbau für Halbleitersubstrate.**

(30) Priorität: **04.09.79 US 72706**

(43) Veröffentlichungstag der Anmeldung:
**11.03.81 Patentblatt 81/10**

(45) Bekanntmachung des Hinweises auf die Patenterteilung:
**10.06.87 Patentblatt 87/24**

(84) Benannte Vertragsstaaten:
**DE FR GB IT**

(56) Entgegenhaltungen:
**DE-A-2 613 759**
**FR-A-2 376 519**
**US-A-3 640 812**
**US-A-3 900 944**

(73) Patentinhaber: **International Business Machines Corporation, Old Orchard Road, Armonk, N.Y. 10504 (US)**

(72) Erfinder: **Howard, James Kent, Cedar Hill Road, Fishkill, NY 12524 (US)**
Erfinder: **White, James Francis, 17 Lake View Drive, Newburgh, NY 12550 (US)**

(74) Vertreter: **Rudack, Günter O., Dipl.- Ing., IBM Corporation Säumerstrasse 4, CH- 8803 Rüschlikon (CH)**

**Beschreibung**

Die Erfindung betrifft einen elektrisch leitenden Kontakt- oder Metallisierungsaufbau für Halbleitersubstrate.

Dünne, schmale, leitende Schichten oder Leitungen sowie Kontakte werden seit einigen Jahren für Halbleiter- und integrierte Schaltungen für Anschlußkontakte und Verbindungsleitungen benutzt. Mit zunehmend geringeren Abmessungen solcher Schaltungen müssen auch die Abmessungen der Leitungsmuster entsprechend verringert werden. Dies hat jedoch zur Folge, daß auch die Stromdichte in diesen Leitungen und Kontakten entsprechend zugenommen hat. Bei diesen höheren Stromdichten treten jedoch bei derartigen Leitungsmustern Störungen auf, die durch Elektromigration verursacht werden, wodurch die Zuverlässigkeit damit ausgerüsteter Schaltungen drastisch eingeschränkt wird. Eine ins einzelne gehende Beschreibung der Elektromigration findet sich beispielsweise in der DE-A-2 647 566.

Somit muß man bei der Herstellung der ersten Metallisierungsebene für integrierte Schaltungen wegen der geringen Abmessungen, d. h. der geringen Dicke des Leitungsmusters ein Metall verwenden, das stärkere Ströme aushalten kann. Dieses Metall soll außerdem an elektrisch isolierenden Schichten, auf denen das Metall aufgebracht werden soll, gut haften. Außerdem soll das Metall keinerlei Einflüsse auf die verschiedenen Übergänge und diffundierten Zonen innerhalb des Substrat der Halbleitervorrichtung ausüben.

Gold hat eine hohe Leitfähigkeit und kann auch Ströme mit hoher Stromdichte aufnehmen. Gold haftet jedoch nicht an Siliciumdioxid, so daß Gold nicht urmittelbar für die erste Metallisierungsebene in Halbleiterschaltungen verwendet werden kann. Außerdem erfordert die Verwendung einer Goldmetallisierung für Verbindungsleitungen in integrierten Schaltungen eine Diffusionssperrschicht, die verhindert, daß das Gold in das darunter liegende Halbleitersubstrat eindiffundiert, insbesondere dann, wenn es sich dabei um Silicium handelt. Es ist bekannt, daß mit Gold dotiertes Silicium die Lebensdauer von Minoritätsladungsträgern beträchtlich verringert, aber was noch wichtiger ist, der eutektische Punkt von Silicium-Gold liegt bei 370°C, und somit besteht die Möglichkeit, daß sich eine flüssige Legierung bildet, wenn die Vorrichtung einer wiederholten Wärmebehandlung unterzogen wird.

Man hat bereits vorgeschlagen, wie dies der US-A-3 717 563 vom 20. Februar 1973 und der US-A-3 900 944 vom 19. Dezember 1973 entnommen werden kann, zwischen Gold und Siliciumdioxid wie auch bei Kontaktstrukturen für Siliciumsubstrate Tantal einzusetzen. Die US-A-3 900 944 und die DE-A-2 613 759 schlagen außerdem für den gleichen Zweck die Verwendung einer TiW-Schicht vor. Es war ferner angenommen worden, daß TiW und Tantal Diffusionssperrschichten zwischen Gold und dem Siliciumsubstrat bilden und damit auch verhindern würden, daß Gold die verschiedenen Übergänge und Zonen in dem Siliciumsubstrat beeinflußt. Es wurde jedoch festgestellt, daß Gold bei 400°C rasch durch TiW- und Tantalschichten hindurch in das Substrat eindiffundiert, so daß diese Stoffe nicht als Diffusionssperrschicht verwendet werden können. Außerdem werden TiW-Schichten starken Spannungen ausgesetzt, wenn sie mehrere Temperaturzyklen durchlaufen, so daß auch Risse in der TiW-Schicht auftreten können, so daß das Gold urmittelbar in das Substrat eindringen kann, wo es mit dem Silicium reagiert.

Gemäß einem weiteren Vorschlag soll die durch Elektromigration auftretende Schwierigkeit dadurch gelöst werden, daß eine Schichtenfolge verwendet wird, bei der eine Goldschicht zwischen zwei Tantalschichten eingebettet liegt, wobei eine dieser beiden Tantalschichten unmittelbar auf dem Substrat aufliegt. Diese Schichtenfolge wird dann erhitzt, wodurch eine Reaktion zwischen dem Gold und dem Tantal zur Bildung einer intermetallischen Verbindung eingeleitet wird.

Obgleich eine derartige zusammengesetzte Metallisierung eine brauchbare Lösung für den Einsatz auf dielektrischen Oberflächen (z. B. SiO$_2$) zu geben scheint, so taucht hier doch die Frage auf, wie sich eine solche zusammengesetzte Metallisierungsschicht in Berührung mit Teilen eines Siliciumsubstrats bei Durchlaufen von Temperaturzyklen bei hoher Temperatur verhält. Dabei besteht die Möglichkeit, daß das Gold durch die Tantalschicht in das Substrat eindiffundiert, das im Falle von Silicium mit Gold reagiert oder legiert.

Weitere Hinweise, Gold für eine leitende Metallisierung anzupassen, finden sich in der DE-A-2 104 672, in der ein aus Tantal-Gold-Tantal-Schichten bestehender Leiter offenbart ist, sowie in der US-A-3 808 041, in der ein Schichtenleiter aus Pt/Au/Pt offenbart ist, und in der US-A-3 893 160, die einen zusammengesetzten Schichtenleiter aus Ti/Mo/Au offenbart.

Wie sich aus diesen Darlegungen ohne weiteres ableiten läßt, wird die der Erfindung zugrunde liegende Aufgabe darin gesehen, für die Verwendung in integrierten Halbleiterschaltungen einen zusammengesetzten Leiter für aus Gold bestehende Leitungsmuster zu schaffen, der nicht nur einen erhöhten Widerstand gegen Elektromigration aufweist, sondern außerdem auch Diffusionssperrschicht-Eigenschaften aufweist, wie sie für integrierte Schaltungen erforderlich sind.

Diese der Erfindung zugrunde liegende Aufgabe wird in der im Patentanspruch angegebenen Weise gelöst. Weitere Ausgestaltungen der Erfindung sind den Unteransprüchen im einzelnen zu entnehmen.

Die Erfindung wird nunmehr anhand von Ausführungsbeispielen in Verbindung mit den beigefügten Zeichnungen im einzelnen näher erläutert. Dabei zeigen

Fig. 1 - 3 schematisch Schnittansichten verschiedener Anwendungsgebiete der erfindungsgemäßen Metallisierung sowie einzelne Stufen bei der Herstellung eines Kontaktaufbaus,

Fig. 2A schematisch eine Schnittansicht einer gegenüber Fig. 2 abgewandelten Ausführungsform und

Fig. 3A und 3B schematisch verschiedene Ausführungsformen des in Fig. 3 gezeigten Kontaktaufbaus, sowie

Fig. 4 - 6 Diagramme zur Darstellung der bei der Auswertung der Erfindung gewonnenen Daten.

Kurz gesagt besteht die Lösung der der Erfindung zugrunde liegenden Aufgabe darin, daß auf dem Halbleitersubstrat eine zusammengesetzte Metallisierung niedergeschlagen wird, die durch das aufeinanderfolgende Niederschlagen von Schichten aus TiW (z. B. 10 Gewichtsprozent Titan und 90 Gewichtsprozent Wolfram), Ta (Tantal) und Au (Gold) bestehen. Dieser Aufbau wird dann bei erhöhten Temperaturen solange angelassen, bis sich in der Tantalschicht eine Zone einer intermetallischen Verbindung zwischen Gold und Tantal bildet (AuTa). Bei erhöhten Temperaturen gibt es eine Interdiffusion zwischen Gold und Tantal bei Temperaturen von etwa 350°C, wobei oberhalb von 350°C das Gold in das Tantal eindiffundiert. Das Gold reagiert mit dem Tantal und bildet an den Korngrenzen des Goldes eine intermetallische Verbindung AuTa und dazwischen an der Trennfläche zwischen Ta- und TiW-Schicht, wo sich die intermetallische Verbindung AuTa nahe an der TiW-Sperrschicht anhäuft. Ein zusätzlicher Vorteil dieser zusammengesetzten Schicht liegt darin, daß das Tantal alle Risse oder Sprünge in der TiW-Schicht ausfüllt, wo es mit dem Gold reagiert und die intermetallische Verbindung AuTa bildet.

Der hier verwendete Ausdruck intermetallische Verbindung stellt mehr als eine Mischung in der Form einer Legierung dar. Vielmehr soll dieser Ausdruck sich auf einen Stoff beziehen, der aus Atomen der beiden verschiedenen Elemente mit bestimmten Proportionen an Atomen der Einzelelemente besteht, wobei diese Verbindung am besten durch eine chemische Formel dargestellt werden kann. Für weitere Einzelheiten bezüglich intermetallischer Verbindungen und der Definition solcher Verbindungen wird auf "Elements of Physical Metallurgy" von A. G. Guy, veröffentlicht bei Addison-Wesley (1951) hingewiesen.

Obwohl es für die Erfindung viele Anwendungsgebiete gibt, so ist sie doch besonders und unmittelbar von Interesse für die Herstellung von Halbleitervorrichtungen in einem mit oxidiertem monokristallinem Silicium überzogenen Substrat mit durchgehenden Kontaktbohrungen in der Oxidschicht für eine Verbindung nach den darunter liegenden Teilen des Substrats. Diese Halbleitervorrichtungen können dabei Transistoren, ladungsgekoppelte Vorrichtungen, Schottky-Sperrschichtdioden und andere elektronische Bauelemente oder diskrete und integrierte Vorrichtungen sein, die Metallisierungen oder Leitungszüge hoher Qualität nach Halbleiterübergängen oder Trennflächen benötigen. In solchen Anwendungen kann die zusammengesetzte Gold-Metallisierung für Verbindungsleitungsnetzwerke, ohmsche Kontakte sowie auch für Schottky-Sperrschichtdioden eingesetzt werden.

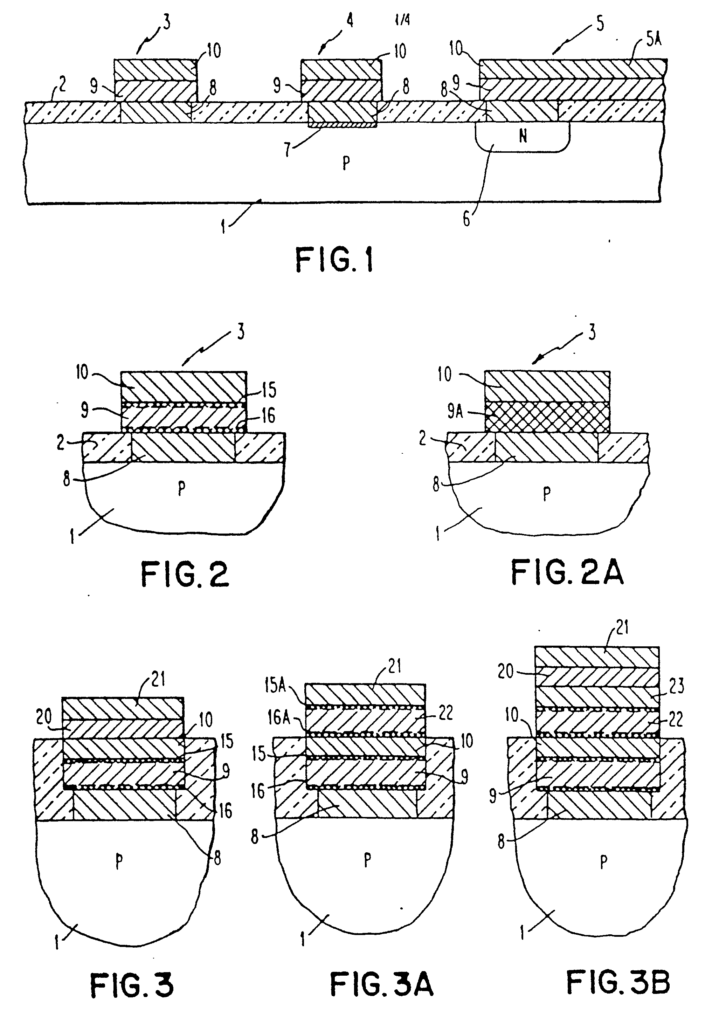

In Fig. 1 ist ein Substrat 1 dargestellt, das in diesem Ausführungsbeispiel der Erfindung aus monokristallinem Silicium besteht, das normalerweise an der Oberfläche oxidiert wird und damit eine darüberliegende dielektrische Schicht 2 aufweist, die hier beispielsweise aus Siliciumdioxid besteht, wobei, falls gewünscht, die Oxidschicht außerdem noch mit einer Siliciumnitridschicht oder einem weiteren ergänzenden dielektrischen Material überzogen werden kann. Dieses Substrat soll im Zusammenhang mit der vorliegenden Erfindung für die Herstellung von Halbleitervorrichtungen benutzt werden, und somit soll das Halbleitersubstrat eine integrierte Schaltung enthalten, die aktive und passive Bauelemente enthält (nicht gezeigt), sowie Mittel, um die einzelnen Bauelemente elektrisch gegeneinander zu isolieren. Obgleich die Erfindung ein weites Anwendungsgebiet haben kann, einschließlich der Herstellung ohmscher Kontakte und Verbindungsleitungs-Metallisierungen, wird die Erfindung nunmehr insbesondere in bezug auf die Herstellung eines Kontakts einer Schottky-Sperrschichtdiode 3 mit niedriger Potentialschwelle beschrieben. Selbstverständlich kann die Erfindung genauso gut für Schottky-Sperrschichtdioden 4 mit hoher Potentialschwelle und ohmsche Kontakte mit einem Verbindungsleitungsmuster 5 für diffundierte Zonen 6 eingesetzt werden, die beispielsweise freiliegende Abschnitte von Emitter-Basis- und Kollektor-Zonen von Transistoren enthalten kann. Andererseits ist es klar, daß die diffundierten Zonen 6 auch Source und Drain von Feldeffekttransistoren darstellen können.

Bei einer solchen Anwendung wird die dielektrische Schicht 2 eine Reihe von Kontaktbohrungen oder durchgehenden Bohrungen für einen Kontakt mit aktiven und passiven Bauelementen sowie für die Herstellung von Schottky-Sperrschichtdioden auf der Oberfläche des Siliciumsubstrats 1 aufweisen. Zur weiteren Erläuterung der Anwendung der Erfindung bildet die zusammengesetzte Metallisierung 4 einen Kontakt für eine Schottky-Sperrschichtdiode hoher Potentialschwelle mit einer Platinsilicidschicht 7, die durch übliche Verfahren gebildet werden kann. Diese Schicht kann beispielsweise durch Verdampfen oder Kathodenzerstäubung in Form eines 50 nm dicken Niederschlags aus Platin gebildet werden, welche Schicht anschließend in einer inerten Atmosphäre, z. B. aus Stickstoff bei etwa 500°C zur Bildung von Platinsilicid behandelt wird. Das Platin reagiert nur mit monokristallinem Material, während mit dem Oxid der dielektrischen Schicht 2 keine Reaktion stattfindet. Nach der Wärmebehandlung kann das nicht umgesetzte Platin, beispielsweise das auf der Oxidschicht liegende Platin durch ein geeignetes Lösungsmittel, wie z. B. Königswasser, entfernt werden, das jedoch das Platinsilicid nicht angreift.

Jede der leitenden Einzelschichten 3, 4, 5 (sowie auch das den Leitungsanschluß bildende Stück 5a) besteht aus einer Schichtenfolge einer TiW-Schicht 8, einer Übergangsmetallschicht 9 (ausgewählt aus der Tantal, Niob, Hafnium und Zirkon enthaltenden Gruppe) und einer Goldschicht 10. Die eigentliche Schaltung oder die Herstellung der Kontakte selbst kann durch verschiedene übliche Verfahren durchgeführt werden. Beispielsweise können ablösbare Masken eingesetzt werden, über denen die einzelnen metallischen Schichten nacheinander niedergeschlagen werden, oder die einzelnen metallischen Schichten können zunächst alles überdeckend über dem Substrat niedergeschlagen werden und anschließend durch nasse oder trockene Ätzverfahren, beispielsweise durch reaktives Ionenätzen selektiv entfernt werden.

Die Kontaktschichten 3, 4 und 5 können durch einen Niederschlag einer TiW-Sperrschicht über dem Substrat mit einer Dicke gebildet werden, die normalerweise im Bereich zwischen 30 nm und etwa 150 nm, beispielsweise bei 100 nm liegt, und zwar durch entsprechende Verfahren, wie z. B. Verdampfung im Vakuum oder vorzugsweise durch Kathodenzerstäubung.

Im nächsten Verfahrensschritt wird eine dünne Schicht mit einer Stärke von etwa 30 rm bis 150 nm, beispielsweise etwa 100 nm eines Übergangsmetalls Tx aus der Tantal, Niob, Hafnium oder Zirkon enthaltenden Gruppe alles überdeckend über die TiW-Schicht niedergeschlagen, wiederum durch Verdampfung oder Kathodenzerstäubung. Nach Niederschlag des Übergangsmetalls wird eine Goldschicht alles überdeckend mit einer Stärke von etwa 200 nm bis etwa 1000 nm, beispielsweise 240 nm über der Tantalschicht ebenfalls durch Verdampfung oder vorzugsweise durch Kathodenzerstäubung niedergeschlagen.

Zu diesem Zeitpunkt können die zusammengesetzten, alles überdeckenden Schichten TiW-Tx-Au durch Maskierung und Ätzverfahren in die einzelnen leitenden Elemente 3, 4 und 5 umgeformt werden. Andererseits wird bei Verwendung von abziehbaren Masken die Metallisierung auf vorher definierten Photolackmasken niedergeschlagen werden, wobei diese Definition der Masken durch Elektronenstrahl- oder Photolithographie durchgeführt wird, worauf dann diese Maske chemisch in einem geeigneten Lösungsmittel entfernt werden kann, so daß die Leiterelemente 3, 4 und 5 übrig bleiben. Andererseits kann die alles überdeckend aufgebrachte, zusammengesetzte Metallisierungsschicht durch reaktives Ionenätzen unter Verwendung von entsprechenden Trockenätzmasken entfernt werden.

In jedem Fall wird das Substrat mit der darüber liegenden zusammengesetzten TiW-Tx-Au-Metallisierung erhitzt oder angelassen, so daß eine Reaktion zwischen dem Gold und dem Übergangsmetall stattfindet. Zu diesem Zweck wird diese zusammengesetzte Schichtfolge auf eine Temperatur zwischen etwa 300° C und etwa 525° C erwärmt, und diese Temperatur wird dabei solange gehalten, bis sich Gold-Übergangsmetallverbindungen oder intermetallische Verbindungen bilden können. Sobald die Temperaturen über 350° C hinaus erhöht werden, nimmt die Diffusion von Gold in das Übergangsmetall zu, wobei das Gold an der Trennfläche zwischen TiW-Schicht und Übergangsmetallschicht eine intermetallische Verbindung mit dem Übergangsmetall eingeht und sich nahe an der TiW-Sperrschicht ablagert. Gleichzeitig dringt das Übergangsmetall in irgendwelche Risse, Spalte oder Löcher in der TiW-Schicht ein, wo es mit dem Gold zu einer intermetallischen Verbindung reagiert. Wie in Fig. 2 gezeigt, bildet die Gold enthaltende intermetallische Verbindung Diffusionssperrzonen 15 und 16 in der aus einem Übergangsmetall bestehenden Diffusionssperrschicht 9.

Wie aus Fig. 2a zu erkennen, läßt sich die aus einem Übergangsmetall bestehende Schicht 9 durch eine intermetallische Schicht 9a aus Gold und einem Übergangsmetall mit einer Dicke von etwa 30 nm bis etwa 150 nm ersetzen. Diese intermetallische Schicht kann über der TiW-Schicht 8 durch irgendein dazu geeignetes Verfahren, vorzugsweise durch Hochfrequenzzerstäubung aus einer vorlegierten Prallplatte des Materials, wie z. B. einer vorlegierten Prallplatte aus Gold und Tantal erzeugen. Es ist jedoch einleuchtend, daß Verdampfung und gemeinsames Niederschlagen aus zwei verschiedenen Quellen zur Herstellung der intermetallischen Phase ebenfalls Verwendung finden kann.

Nachdem die aus Gold bestehende Schicht 10 auf der Tantalschicht niedergeschlagen und angelassen worden ist, wird eine das Haftvermögen erhöhende Schicht (nicht gezeigt) z. B. Ta und/oder TiW, gefolgt von einer dielektrischen Schicht (nicht gezeigt) von beispielsweise $SiO_2$ niedergeschlagen und haftet daran und bildet somit eine elektrisch isolierende Schicht, auf der die zweite Metallisierungsebene niedergeschlagen werden kann.

Fign. 3, 3A und 3B zeigen die Anpassung dieser Metallisierung für die Bildung von Lötkontakten und Anschlußkontakten, welche verhindern, daß Gold aus der Hauptmetallisierung mit dem Lot und/oder Kupfer in Wechselwirkung tritt. Die einfachste Ausführungsform zeigt Fig. 3 entsprechend den Lehren der US-A-3 401 055 vom 10. September 1968 und dem IBM Technical Disclosure Bulletin mit dem Titel "Metallurgy Barrier for Au and Pb" von M. Revitz u.a., Seite 3358, Band 14, Nr. 11, vom April 1972. Zu diesem Zweck wird eine Metallisierungssperrschicht 20 auf der Goldschicht 10 niedergeschlagen, die aus einer Schichtenfolge von Chrom, Kupfer und Gold besteht, worauf dann die eigentliche Lötschicht 21 niedergeschlagen wird. In diesem Fall dient die Chromschicht für eine bessere Haftung an Glas, Siliciumoxid, und als eine Schutzschicht für das Chrom läßt sich die Kupferschicht leicht an Chrom anlöten, und die Goldschicht verhindert die Oxidation der Kupferschicht. In Fig. 3A erhält man einen noch besseren Schutz für die Goldmetallisierung gemäß der Erfindung dadurch, daß eine Tantalschicht 22 vorgesehen wird, die nach Anlassen oder Wärmebehandlung mit dem Gold reagiert und die intermetallische Sperrschicht 15A und 16A bildet. Eine weitere Schutzschicht kann gemäß Fig. 3B dadurch erzielt werden, daß eine weitere Sperrschicht 23 aus TiW zwischen der Tantalschicht 22 und der Metallisierungssperrschicht 21, d. h. zwischen der Tantalschicht 22 und der Chromschicht der Metallisierungsschicht 21 vorgesehen wird.

Für eine Auswertung der zusammengesetzten Goldmetallisierung gemäß der Erfindung wurden Widerstandsmessungen aufgedampfter Schichten aus 240 nm Gold/100 nm Ta oder Nb/100 nm TiW auf Silicium vorgenommen und mit Schichtenfolgen aus 240 nm Au/100 nm Ta oder Nb auf Silicium verglichen. Dies dient der Feststellung der prozentualen Zunahme des Widerstandes ($\Delta R\%$) mit den Anlaßtemperaturen (immer für eine Stunde) als ein Maß für die Verluste an Gold durch Diffusion durch die Sperrschicht hindurch. Die Ergebnisse sind in der nachfolgenden Tabelle I dargestellt.

**Tabelle I**

ΔR%

| | | 300°C | 350°C | 400°C | 450°C | 500°C |
|---|---|---|---|---|---|---|
| 1. | Au/Nb | 0 | +21 | +450 | | |
| 2. | Au/Ta | -7.7 | -4.4 | +277 | | |
| 3. | Au/Nb/TiW* | 0 | 0 | +29 | +50 | +125 |
| 4. | Au/Ta/TiW | 0 | - | +3.4 | +12.6 | |

* Au/Nb reagiert leichter zur Bildung von $Au_2Nb$ als Au/Ta zur Bildung von TaAu reagiert, somit ist ΔR% für AuNb größer als für AuTa.

Eine Auger-Analyse von Au/Nb/TiW und Au/Ta/TiW-Schichtenfolgen nach Anlassen bei 450°C zeigten, daß die Au/Nb-Reaktion zur Bildung der intermetallischen Phase intensiver war als für Au/Ta und daher das größere ΔR% ergab. Die Auger-Daten zeigten jedoch keinen Unterschied in der Struktur der Metallisierung in bezug auf das Eindringen von Gold in Silicium. Es kann daher extrapoliert werden, daß die Au-Nb-Reaktion zur Bildung der intermetallischen Phase das Diffusionsvermögen von Gold beschränkt.

Außerdem wurden die Diffusionssperrschichten von Au/Ta/TiW/Si-Strukturen mit den Au/Ta/Si und Au/TiW/Si-Strukturen verglichen. Die Dickenverhältnisse bei aufgedampftem Au:Ta:TiW waren etwa 300:80:100 nm. Die Schichtdicken von Au:Ta und Au:TiW-Schichten waren demgemäß 300:80 nm und 300:100 nm. Die Metallisierung bestand aus gleichförmigen Schichten der zusammengesetzten Schichtenfolge auf frisch gereinigten Siliciumsubstraten mit <100> Orientierung. Die Reaktion und Interdiffusion von Gold mit den Sperrschichten und Silicium wurde durch verschiedene Verfahren ermittelt:
 a) Änderungen im Flächenwiderstand (makroskopische Reaktion),
 b) Auger-Spektroskopie (Interdiffusion) und
 c) Durchstrahlungs-Elektronenmikroskopie (TEM) und Rasterelektronermikroskopie (SEM) (Phasenbildung und Mikrostruktur).
 Die anschließend wiedergegebene Tabelle II enthält das Ergebnis dieser Untersuchungen.

**Tabelle II**

AuSi-Reaktion der Sperrschichtmetallisierung nach der genau angegebenen Anlaßzeit von einer Stunde mittels Durchstrahlungs-Elektronenmikroskop und Rasterelektronenmikroskop

| | 300°C | 350°C | 400°C | 450°C | 500°C |
|---|---|---|---|---|---|
| Au/Ta | nein | ja | ja | ja | ja |
| Au/TiW | nein | nein | ja* | ja | ja |
| Au/Ta/TiW | nein | nein | nein | nein | nein |

* basierend auf optimaler Überprüfung von Siliciumsubstraten nach dem Anlassen und Abziehen des Metalls.

Die AuSi-Reaktion kann nach dem Anlassen festgestellt werden, d. h. die Reaktionszonen können in dem Silicium in Form von facettierten Löchern festgestellt werden. Über den Löchern im Silicium tritt dann in der metallischen Schicht eine Vertiefung auf. Die mittels Elektronenmikroskopie gewonnenen Daten lassen vermuten, daß die AuSi-Reaktion für Wärmebehandlungen von 500°C (für eine Stunde) oder mehr mit Ta/TiW-Sperrschichten verhindert werden kann.

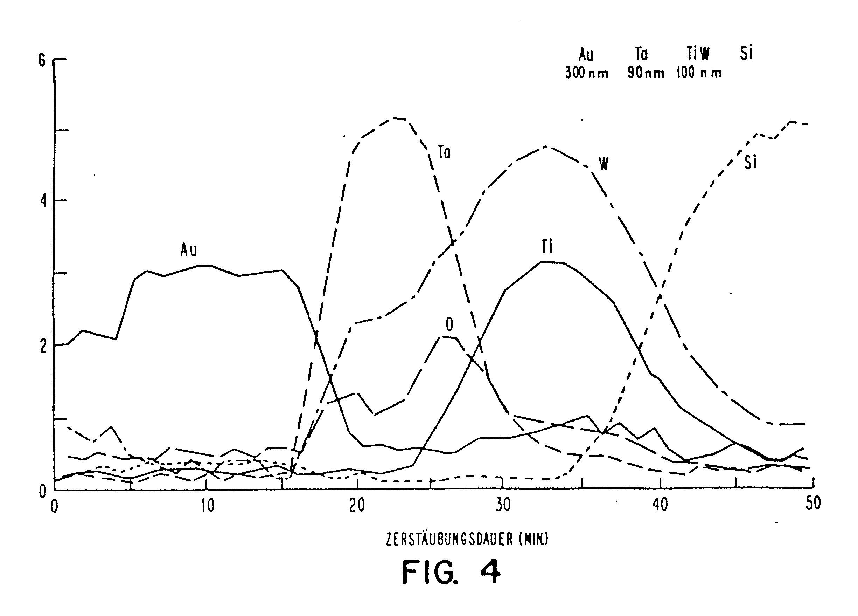

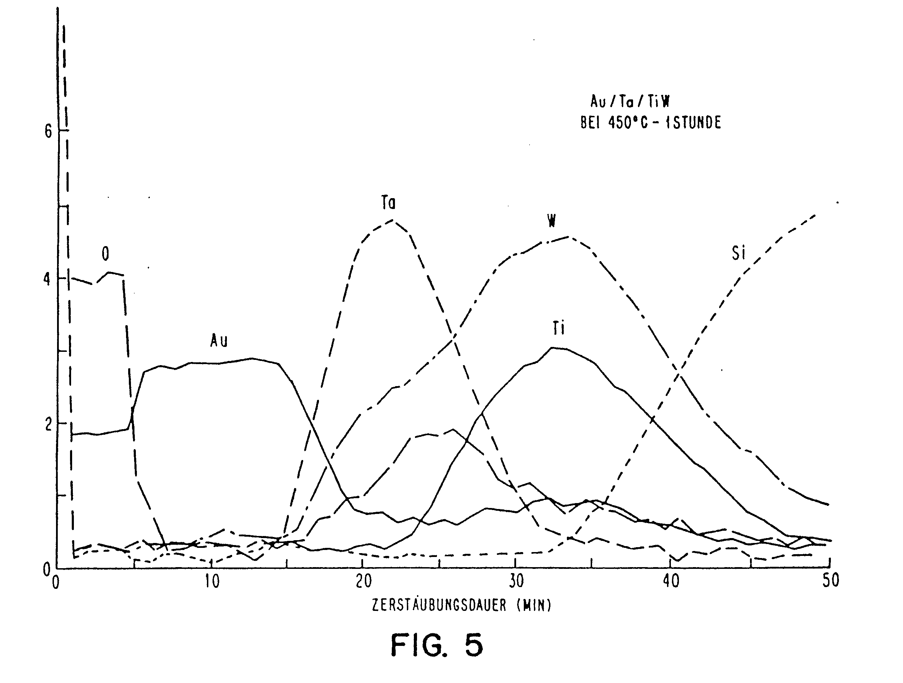

Die Auger-Daten wurden von Halbleiterplättchen (Schnitten) der bei der Elektronenstrahluntersuchung verwendeten Plättchen gewonnen. Ein zusammengesetztes Tiefenprofil der Au/Ta/TiW/Si-Probe vor dem Anlassen ist in Fig. 4 gezeigt. Nach dem Anlassen bei 450°C für eine Stunde zeigt das Tiefenprofil der Zusammensetzung (Fig. 5), daß das Au-Signal unverändert ist, d. h. daß an der Trennfläche TiW-Si keine Anhäufung von Gold auftritt. Somit wird also eine Au-Si-Reaktion durch eine Ta/TiW-Sperrschicht für Wärmebehandlungen von mindestens 450°C verhindert.

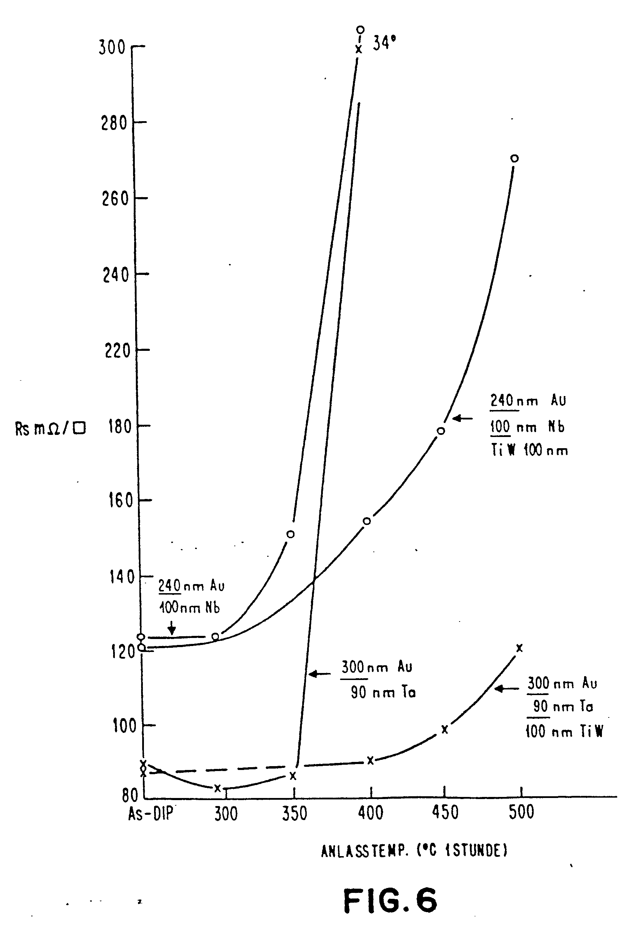

Flächenwiderstandsmessungen von Au/Ta/TiW/Si, Au/Ta/Si, Au/Nb/TiW/Si und Au/Nb/Si Strukturen sind in Fig. 6 gezeigt. Es sei darauf hingewiesen, daß sowohl Au/Ta/Si und Au/Nb/Si bei 400°C katastrophale Zusammenbrüche zeigen (starke Zunahme im Widerstand wegen der eutektischen Au-Si-Reaktion).

Die Au/Ta/TiW-Proben zeigten jedoch lediglich eine etwa 30%ige Zunahme des Gesamtwiderstandes nach Anlassen bei 300°C, 350°C, 400°C, 450° und 500° für eine Stunde (die gleiche Schicht wurde für die Erzeugung

5

der Daten in Fig. 6 benutzt). Die geringfügige Widerstandszunahme wird auf die Bildung der AuTa-Phase zurückgeführt und nicht auf eine Au-Si-Reaktion, wie dies mit Hilfe des Durchstrahlungs-Elektronenmikroskops festgestellt wurde.

**Patentansprüche**

1. Elektrisch leitender Kontakt- oder Metallisierungsaufbau für Halbleitersubstrate, bei dem eine an das Substrat (1) anschliessende, aus einer Legierung von Titan mit Wolfram bestehende Kontakt- oder Metallisierungsschicht (8) sowie eine auf der dem Substrat (1) abgewandten Seite der Titan-Wolframschicht (8) angeordnete Goldschicht (10) vorgesehen ist, dadurch gekennzeichnet, dass zwischen der Titan-Wolframschicht (8) und der Goldschicht (10) eine die gesamte Titan-Wolframschicht abdeckende, aus einer intermetallischen Verbindung von Gold mit einem Übergangsmetall der Gruppe Tantal, Hafnium, Zirkon, Niob bestehende Diffusionssperrschicht (9) vorgesehen ist.

2. Kontakt- oder Metallisierungsaufbau nach Anspruch 1, dadurch gekennzeichnet, dass das Substrat (1) aus Silicium besteht und dass die Kontakt- oder Metallisierungsschicht (8) sich daran unmittelbar anschliesst.

3. Kontakt- oder Metallisierungsaufbau nach Anspruch 1, dadurch gekennzeichnet, dass zwischen der Kontaktschicht (8) und dem aus Silicium bestehenden Substrat (1) ein aus Platinsilicid bestehender Schottky-Potential-Sperrschichtkontakt (7) vorgesehen ist.

4. Kontakt- oder Metallisierungsaufbau nach Anspruch 1, dadurch gekennzeichnet, dass die Diffusionssperrschicht (9) eine aus dem Übergangsmetall bestehende Schicht umfasst, die die Diffusionssperrzone (15, 16) enthält.

5. Kontakt- oder Metallisierungsaufbau nach Anspruch 1, dadurch gekennzeichnet, dass das Übergangsmetall Tantal ist.

**Claims**

1. Electrically conductive contact or metallizing structure for semiconductor substrates comprising a contact or metallizing layer (8) adjacent said substrate (1) and consisting of an alloy of titanium and tungsten, and a gold layer (10) arranged on that side of the titanium/tungsten layer (8) which is opposite from the substrate (1), characterized in that between said titanium/tungsten layer (8) and said gold layer (10) there is provided a diffusion barrier layer (9) overlaying the entire titanium/tungsten layer (8) and consisting of an intermetallic compount of gold with a transition metal of the group comprising tantalum, hafnium, zirconium, and niobium.

2. Contact or metallizing structure in accordance with claim 1, characterized in that the substrate (1) consists of silicon, and that the contact or metallizing layer (8) is immediately adjacent thereto.

3. Contact or metallizing structure in accordance with claim 1, characterized in that between said contact layer (8) and said substrate (1), consisting of silicon, there is provided a Schottky potential barrier contact (7) consisting of platinum silicide.

4. Contact or metallization structure in accordance with claim 1, characterized in that the diffusion barrier layer (9) encompasses a layer consisting of the transition metal, which comprises the diffusion barrier region (15, 16) therein.

5. Control or metallization structure in accordance with claim 1, characterized in that the transition metal is tantalum.

**Revendications**

1. Structure électriquement conductrice à contact ou à métallisation pour des substrats semiconducteurs, dans laquelle il est prévu une couche de contact ou de métallisation (8) qui se raccorde au substrat (1) et est constituée en un alliage de titane et de tungstène, ainsi qu'une couche d'or (10) disposée sur la face, située à l'opposé du substrat (1), de la couche de titane-tungstène (8), caractérisée par le fait qu'il est prévu entre la couche de titane-tungstène (8) et la couche d'or (10), une couche d'arrêt (9) empêchant une diffusion, recouvrant l'ensemble de la couche de titane-tungstène et constituée par un composé intermétallique d'or et d'un métal de transition du groupe incluant le tantale, le hafnium, le zirconium et le niobium.

2. Structure à contact ou à métallisation selon la revendication 1, caractérisée en ce que le substrat 1, est constitué par du silicium et que la couche de contact ou de métallisation (8) se raccorde directement au substrat.

3. Structure à contact ou métallisation selon la revendication 1, caractérisée en ce qu'il est prévu, entre la couche de contact (8) et le substrat (1) constitué par du silicium, un contact (7) formant barrière de Schottky, constituée par du siliciure de platine.

4. Structure à contact ou métallisation selon la revendication 1, caractérisée en ce que la couche d'arrêt (9)

6

empêchant la diffusion comprend une couche constituée par le métal de transition et qui contient la zone d'arrêt (15, 16) empêchant la diffusion.

5. Structure à contact ou métallisation selon la revendication 1, caractérisée en ce que le métal de transition est du tantale.

1/4

FIG. 1

FIG. 2

FIG. 2A

FIG. 3

FIG. 3A

FIG. 3B

FIG. 4

0 024 572

Au / Ta / TiW
BEI 450°C – 1STUNDE

Ta

W

Si

O

Au

Ti

ZERSTÄUBUNGSDAUER (MIN)

FIG. 5

0 024 572

FIG.6